# EUROPEAN PATENT APPLICATION

(11) **EP 3 748 273 A1**
(43) Date of publication of application: **09.12.2020**
(21) Application number: 20177991.5
(22) Date of filing: 03.06.2020
(51) Int. Cl.: F28D 15/02, F28D 15/04

(54) **EVAPORATOR, LOOP HEAT PIPE, AND ELECTRONIC DEVICE**

(30) Priority: 07.06.2019 JP 2019107159
(71) Applicant: Ricoh Company, Ltd., Tokyo 143-8555 (JP)
(72) Inventor: BABA, Toshihiko, Tokyo, 143-8555 (JP); HIRASAWA, Tomoyasu, Tokyo, 143-8555 (JP); IKEDA, Keisuke, Tokyo, 143-8555 (JP); BANNO, Mayu, Tokyo, 143-8555 (JP)
(74) Representative: SSM Sandmair

(57) **Abstract**

An evaporator (2) for use in a loop heat pipe (1) includes an evaporator body (7) including an internal space; a heat receiving portion (8) forming an outer surface of the evaporator body (7) to receive heat from an outside of the evaporator body (7); an inflow portion (2a) in the internal space, into which a working fluid condensed into a liquid phase by a condenser (3) flows; a discharge portion (2b) in the internal space, to discharge a gas-phase working fluid evaporated by the heat received by the heat receiving portion (8); a wick (6) in the internal space, into which a working fluid flowing into the inflow portion (2a) permeates; and a partition (10) partitioning the internal space into the inflow portion and the discharge portion with the wick. The wick (6) is sandwiched between a surface (10a) of the partition (10) and the heat receiving portion (8).

## Description

### BACKGROUND

### Technical Field

Aspects of the present disclosure relate to a loop heat pipe, an evaporator for use in the loop heat pipe, and an electronic device.

### Related Art

There is known an evaporator for use in a loop heat pipe that includes a heat receiving portion to receive heat from the outside, an inflow portion into which a working fluid condensed into a liquid phase by a condensing portion flows, and a discharge portion to discharge a gas-phase working fluid evaporated by the heat received by the heat receiving portion. The loop heat pipe accommodates a wick, into which the working fluid flowing into the inflow portion permeates, to evaporate the working fluid from the liquid phase to the gas phase.

As an evaporator used for the loop heat pipe, for example, JP-2018-066510-A describes a flat-plate-type evaporator. A flat-plate wick housed in the evaporator is inserted into a body of the evaporator and fitted into the body of the evaporator. Thus, the wick is brought into close contact with an inner peripheral surface of the evaporator parallel to the insertion direction of the wick.

However, in a device described in JP-2018-066510-A, there is room for improvement from the viewpoint of improving workability when the wick is assembled to the evaporator.

### SUMMARY

In an aspect of the present disclosure, there is provided an evaporator for use in a loop heat pipe. The evaporator includes an evaporator body, a heat receiving portion, an inflow portion, a discharge portion, a wick, and a partition. The evaporator body includes an internal space. The heat receiving portion forms an outer surface of the evaporator body to receive heat from an outside of the evaporator body. A working fluid condensed into a liquid phase by a condenser flows into the inflow portion in the internal space. The discharge portion is in the internal space, to discharge a gas-phase working fluid evaporated by the heat received by the heat receiving portion. The working fluid flowing into the inflow portion permeates into the wick in the internal space. The partition partitions the internal space into the inflow portion and the discharge portion with the wick. The wick is sandwiched between a surface of the partition and the heat receiving portion.

In another aspect of the present disclosure, there is provided a loop heat pipe that includes the evaporator and the condenser. The evaporator receives the heat from the outside of the evaporator body to evaporate the working fluid from the liquid phase to a gas phase. The condenser is connected to the evaporator to condense the gas-phase working fluid discharged from the evaporator into the liquid phase.

In still another aspect of the present disclosure, there is provided an electronic device that includes the loop heat pipe.

According to the present disclosure, the wick can be easily assembled to the evaporator. As a result, workability in assembling the wick to the evaporator can be improved.

### BRIEF DESCRIPTION OF THE DRAWINGS

A more complete appreciation of the disclosure and many of the attendant advantages and features thereof can be readily obtained and understood from the following detailed description with reference to the accompanying drawings, wherein:
FIG. 1 is a schematic view of a configuration of a loop heat pipe according to an embodiment of the present disclosure;
FIG. 2 is a schematic view of a configuration of a loop heat pipe according to a comparative example;
FIG. 3 is a diagram illustrating an example of assembling the evaporator according to the comparative example;
FIG. 4 is a schematic view of a configuration of an evaporator of an embodiment of the present disclosure;
FIG. 5 is a cross-sectional view of the evaporator taken along line A-A of FIG. 4;
FIG. 6 is a perspective view of a partition plate;
FIG. 7 is a perspective view of a holder;
FIG. 8 is a cross-sectional view of an evaporator according to a variation;
FIG. 9 is a plan view of a partition plate and a gasket mounted on an evaporator according to the variation of FIG. 8;
FIG. 10 is a schematic view of an example of an electronic device including a loop heat pipe according to an embodiment of the present disclosure; and
FIG. 11 is a schematic view of an example of a cooling target of an electronic device in which a heat receiving plate of an evaporator receives heat.

The accompanying drawings are intended to depict embodiments of the present disclosure and should not be interpreted to limit the scope thereof. The accompanying drawings are not to be considered as drawn to scale unless explicitly noted.

### DETAILED DESCRIPTION

The terminology used herein is for the purpose of describing particular embodiments only and is not intended to be limiting of the present disclosure. As used herein, the singular forms "a", "an" and "the" are intended to include the plural forms as well, unless the context clearly indicates otherwise.

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

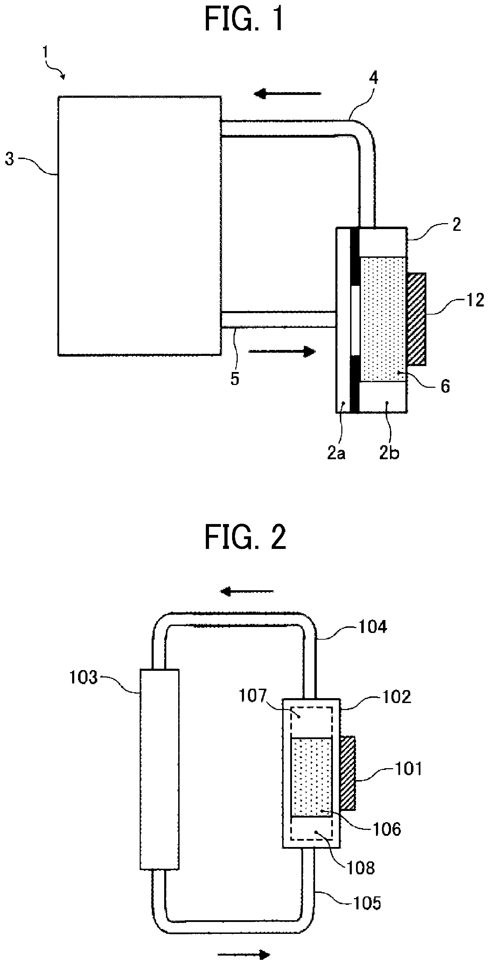

Below, a description is given of a cooling device for an electronic device, including a loop heat pipe according to an embodiment of the present disclosure. FIG. 1 is a schematic view of a configuration of a loop heat pipe according to an embodiment of the present disclosure.

A loop heat pipe 1 according to the present embodiment includes an evaporator 2, a condenser 3, a vapor pipe 4, and a liquid pipe 5. A working fluid is sealed in the evaporator 2. The evaporator 2 absorbs heat from a cooling target 12 to evaporate the working fluid from a liquid phase to a gas phase. The condenser 3 condenses the gas-phase working fluid introduced from the evaporator 2 to a liquid phase. Through the vapor pipe 4, the gas-phase working fluid flows from the evaporator 2 to the condenser 3. Through the liquid pipe 5, the working fluid flows from the condenser 3 to the evaporator 2.

The evaporator 2 transfers heat outside the wall to evaporate the working fluid inside the wall from the liquid phase to the gas phase. The condenser 3 condenses the gas-phase working fluid introduced from the evaporator 2 to the liquid phase. In the present embodiment, ethanol is used as the working fluid. In some embodiments, other condensable fluid such as ammonia, water, alcohol, a fluorine-based solvent such as acetone, or alternative chlorofluorocarbons may be used.

The condenser 3 has a heat radiation pipe that is a condensation tube provided with a large number of thin plate-shaped fins (heat radiation fins) made of aluminum on an outer peripheral surface of the condensation tube. The working fluid passes through the heat radiation pipe, and the heat of the working fluid is dissipated through a wall portion of the heat radiation pipe and the heat radiation fins. One end of the heat radiation pipe is connected to the vapor pipe 4, and the other end of the heat radiation pipe is connected to the liquid pipe 5.

The evaporator 2 is formed of a metal such as copper, a copper alloy, aluminum, an aluminum alloy, or stainless steel, and accommodates a wick 6. The inside of the evaporator 2 is partitioned into a reservoir portion 2a and a discharge portion 2b. The reservoir portion 2a is an inflow portion into which the liquid-phase working fluid flows from the liquid pipe 5. The liquid-phase working fluid is stored in the reservoir portion 2a. Through the discharge portion 2b, the working fluid having been evaporated to a gas phase is discharged to the vapor pipe 4.

The wick 6 is formed of a porous material such as metal or resin, or porous rubber, and has a capillary force. As the porous rubber, for example, foamed silicone rubber or foamed urethane rubber is used. A material having a large number of voids (holes) formed inside, such as ceramic, glass, or fiber, may be used.

The liquid-phase working fluid stored in the reservoir portion 2a permeates the wick 6 by capillary phenomenon. The wick 6 also acts as a pump to send the liquid-phase working fluid from the condenser 3 to the evaporator 2 by the capillary phenomenon.

When the heat from the cooling target 12 is transferred to the liquid-phase working fluid having permeated the wick 6 through the evaporator 2, the working fluid is evaporated by the heat to change into a gas phase. The working fluid evaporated and changed into a gas phase is discharged to the vapor pipe 4. The gas-phase working fluid is sent to the condenser 3 through the vapor pipe 4.

In the condenser 3, since the heat of the working fluid passing through the inside of the condenser 3 is released to the outside via the fins, the temperature of the working fluid is lowered and the working fluid is condensed. Accordingly, the working fluid changes from the gas phase to the liquid phase. The working fluid changed to the liquid phase moves to the evaporator 2 through the liquid pipe 5 and permeates into the wick 6 again by the capillary phenomenon of the wick 6. Such circulation of the working fluid continuously releases the heat of the heat generator to the outside, thus cooling the cooling target 12.

FIG. 2 is a schematic view of a configuration of a loop heat pipe according to a comparative example. In an evaporator 102 of the loop heat pipe according to the comparative example, as illustrated in FIG. 2, a wick 106 is press-fitted into the evaporator 102 and brought into close contact with an inner peripheral surface of a body (housing) of the evaporator 102. Thus, the inside of the evaporator 102 is partitioned into a reservoir portion 108 as a liquid-phase space and a discharge portion 107 as a gas-phase space only by the wick 106.

The discharge portion 107, which is a gas-phase space in the evaporator 102, is filled with a gas-phase working fluid whose volume is expanded by evaporation under heat from a cooling target 101. Accordingly, the discharge portion 107 has a higher pressure than the reservoir portion 108, which is a liquid-phase space in the evaporator 102. Therefore, the gas-phase working fluid in the discharge portion 107 might flow back to the reservoir portion 108. If the gas-phase working fluid in the discharge portion 107 flows back to the reservoir portion 108, the pressure difference between the liquid pipe 105 side and the vapor pipe 104 side decreases, which might hamper circulation of the working fluid through a condenser 103. Therefore, the wick 106 is brought into close contact with the inner peripheral surface of the body of the evaporator 102 to partition the inside of the evaporator 102 into the liquid phase space and the gas phase space, to prevent the gas-phase working fluid in the discharge portion 107 from flowing back to the reservoir portion 108 from between the wick 106 and the inner peripheral surface of the evaporator 102.

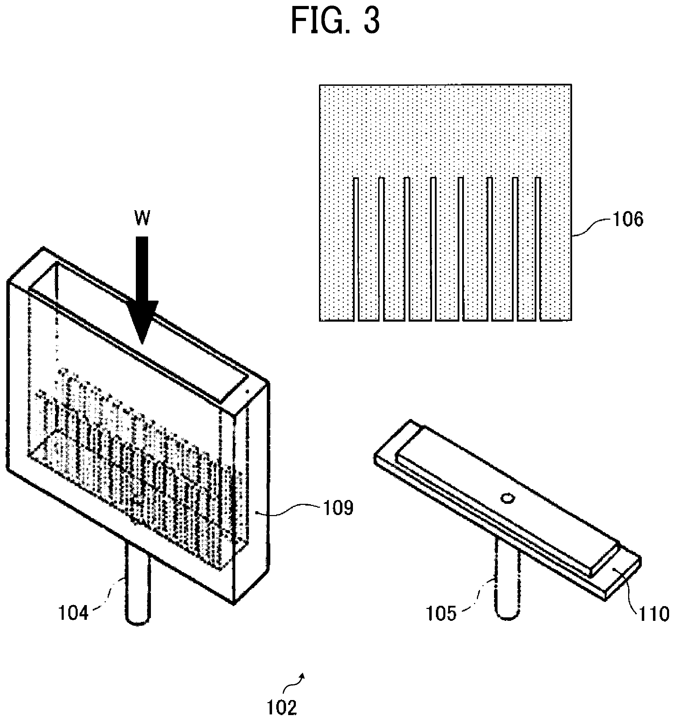

FIG. 3 is a diagram illustrating an example of assembling the evaporator 102 according to the comparative example. In the comparative example, the body of the evaporator 102 includes a box-shaped housing 109 and a lid member 110. The housing 109 has a substantially rectangular parallelepiped shape and an opening at one side. The lid member 110 is connected to the liquid pipe 105 and covers the opening of the housing 109.

The wick 106 is press-fitted into the housing 109 through the opening of the housing 109 in a direction indicated by arrow W in FIG. 3 and is in close contact with an inner circumferential surface of the housing 109 parallel to a wick insertion direction (indicated by arrow W in FIG. 3). Thus, the wick 106 partitions the evaporator 102 into the reservoir portion 108 and the discharge portion 107.

As described above, in the comparative example, the surface of the housing 109 to which the wick 106 is brought into close contact is parallel to the insertion direction of the wick 106 in order to prevent the gas-phase working fluid in the discharge portion 107 from flowing back to the reservoir portion 108. Therefore, the wick 106 is assembled by press fitting. In order to bring the outer peripheral surface of the wick 106 into close contact with the inner peripheral surface of the housing 109 parallel to the insertion direction of the wick 106, it is necessary to make the fitting tight, which makes it difficult to assemble the wick 106 to the evaporator 102. Therefore, improvement in workability has been desired. In particular, when the wick 106 is made of a material such as porous rubber having a large frictional force with the inner peripheral surface of the housing 109, the wick 106 does not slip on the inner peripheral surface of the housing, thus increasing the difficulty of assembling the wick 106.

Hence, in the present embodiment, the evaporator 2 has the following configuration to prevent the gas-phase working fluid in the discharge portion 2b from flowing back to the reservoir portion 2a, thus facilitating assembling of the wick 6 to the evaporator 2. Hereinafter, features of the present embodiment are further described with reference to drawings.

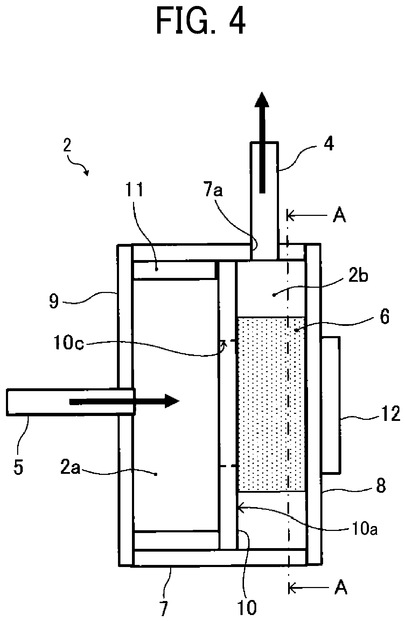

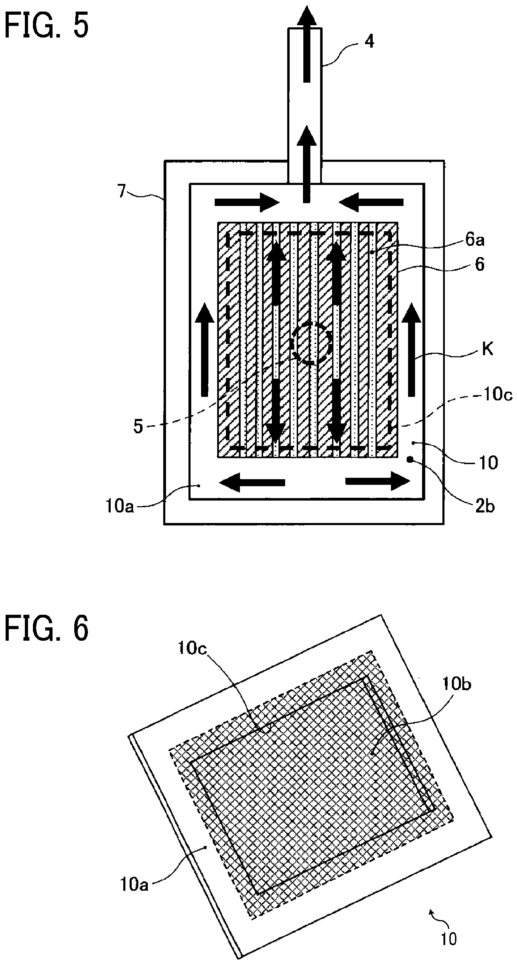

FIG. 4 is a schematic view of a configuration of the evaporator 2 according to the present embodiment. FIG. 5 is a cross-sectional view of the evaporator 2 taken along line A-A of FIG. 4. As illustrated in FIG. 4, the body of the evaporator 2 in the present embodiment includes a housing 7, a liquid-side side plate 9, and a heat receiving plate 8. The housing 7 has a rectangular tubular shape with two open sides. The liquid-side side plate 9 is connected to the liquid pipe 5 and is a lid member to close one opening (liquid-phase-side opening) of the housing 7. The heat receiving plate 8 closes the other opening (gas-phase-side opening) of the housing 7 and is a heat receiving portion to contact the cooling target 12 and receive heat from the cooling target 12. A side wall of the housing 7 includes a discharge port 7a connected to the vapor pipe 4.

The wick 6 is in close contact with the inside of the evaporator 2 and includes a partition plate 10 and a holder 11. The partition plate 10 is a partition that partitions the inside of the evaporator 2 into the reservoir portion 2a and the discharge portion 2b together with the wick 6. The holder 11 holds the partition plate 10 at a predetermined position (a predetermined position in the insertion direction of the wick 6). The holder 11 is disposed (in a reservoir portion) between the liquid-side side plate 9 and the partition plate 10 and holds the partition plate 10 at the predetermined position (the predetermined position in the insertion direction of the wick 6) in a state of supporting the partition plate 10 from the liquid-phase side.

An opening 10c is formed in the center of the partition plate 10. A gas-phase-side surface 10a of the partition plate 10 (a surface facing the heat receiving plate 8) and the heat receiving plate 8 press the wick 6 in opposite directions each other. Thus, the wick 6 is held and sandwiched between the partition plate 10 and the heat receiving plate 8. The liquid-phase working fluid flowing into the reservoir portion 2a of the evaporator 2 passes through the opening 10c of the partition plate 10 and permeates into the wick 6 sandwiched between the partition plate 10 and the heat receiving plate 8 (and disposed in the discharge portion 2b).

As illustrated in FIG. 5, the outer shape size of the wick 6 is smaller than the inner size of the housing 7, and a predetermined gap is formed between the inner peripheral surface of the housing 7 and the outer peripheral surface of the wick 6. On the side facing the heat receiving plate 8, the wick 6 has a plurality of vapor grooves 6a through which the working fluid evaporated into a gas phase flows. The plurality of vapor grooves 6a is arranged side by side in a direction orthogonal to a direction in which the partition plate 10 or the heat receiving plate 8 presses the wick 6. The surface of the wick 6 facing the heat receiving plate 8 is flat.

When the liquid-phase working fluid that has permeated the wick 6 evaporates into a gas phase, the working fluid passes through the vapor grooves 6a, flows through the discharge portion 2b, which is a gas-phase space, as indicated by arrow K in FIG. 5, and is discharged to the vapor pipe 4.

In the present embodiment, the wick 6 is made of porous silicone rubber being an elastic member. The length of the wick 6 in the direction orthogonal to the heat receiving plate 8 when not assembled is longer than the length from the gas-phase-side surface 10a of the partition plate 10, which is a surface portion orthogonal to the insertion direction of the wick 6, to a contact surface of the heat receiving plate 8 with the wick 6. Accordingly, the wick 6 is sandwiched between the partition plate 10 and the heat receiving plate 8 in a state in which the wick 6 is compressed and deformed by the gas-phase-side surface 10a of the partition plate 10 and the heat receiving plate 8.

As described above, the wick 6 is sandwiched between the partition plate 10 and the heat receiving plate 8 in the state in which the wick 6 is compressed and deformed by the gas-phase-side surface 10a of the partition plate 10 and the heat receiving plate 8. Thus, the wick 6 can be brought into close contact with the gas-phase-side surface of the partition plate 10. Such a configuration can prevent the gas-phase working fluid in the discharge portion 2b from flowing back to the reservoir portion 2a from between the wick 6 and the partition plate 10.

The wick 6 is sandwiched between the partition plate 10 and the heat receiving plate 8 in the state in which the wick 6 is compressed and deformed by the gas-phase-side surface 10a of the partition plate 10 and the heat receiving plate 8, thus bringing the wick 6 into close contact with the heat receiving plate 8. Such a configuration allows the heat of the cooling target 12 received by the heat receiving plate 8 to be favorably transferred to the wick 6. Accordingly, the liquid-phase working fluid having permeated the wick 6 can be efficiently evaporated from the liquid phase to the gas phase, thus allowing the cooling effect to be enhanced.

FIG. 6 is a schematic perspective view of the partition plate 10. As illustrated in FIG. 6, a mesh member 10b is attached to the gas-phase-side surface 10a of the partition plate 10 to cover a rectangular opening 10c in the middle of the partition plate 10. Without the mesh member 10b, the wick 6 is not pressed by the opening 10c of the partition plate 10 toward the heat receiving plate 8. As a result, the adhesion between the wick 6 and the heat receiving plate 8 is reduced, and the efficiency of transferring the heat received by the heat receiving plate 8 to the wick 6 may be reduced. Without the mesh member 10b, when the wick 6 is sandwiched and compressed between the partition plate 10 and the heat receiving plate 8, a part of the wick 6 is deformed to enter the opening 10c, thus causing the surface of the wick 6 facing the partition plate 10 to be non-flat. As a result, the adhesion between the gas-phase-side surface 10a of the partition plate and the wick 6 decreases, and the gas-phase working fluid in the discharge portion 2b may flow back to the reservoir portion 2a from between the gas-phase-side surface 10a of the partition plate 10 and the wick 6.

In contrast, the mesh member 10b covering the opening 10c of the partition plate 10 can press a portion of the wick 6 facing the opening 10c of the partition plate 10 toward the heat receiving plate 8. Such a configuration can uniformly press the wick 6 toward the heat receiving plate 8, thus allowing the wick 6 to be uniformly brought into close contact with the heat receiving plate 8.

When the wick 6 is sandwiched and compressed between the partition plate 10 and the heat receiving plate 8, the mesh member 10b covering the opening 10c can prevent a part of the wick 6 from being deformed to enter the opening 10c. As a result, the wick can be compressively deformed in a state in which the surface of the wick 6 facing the partition plate 10 is maintained as a flat surface, thus restraining a decrease in adhesion between the gas-phase-side surface 10a of the partition plate and the wick 6.

Further, since the member covering the opening 10c is a mesh member, the liquid-phase working fluid in the reservoir portion 2a can permeate into the wick 6 through the opening 10c.

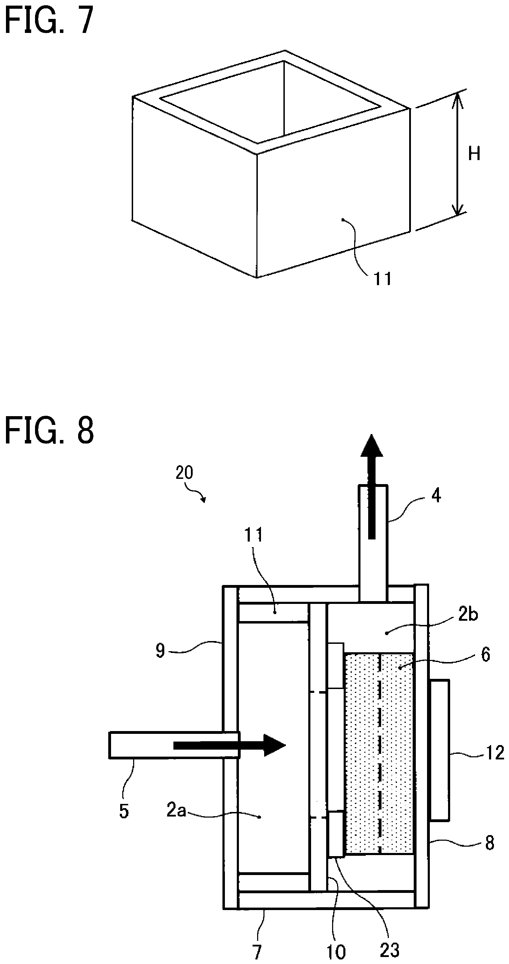

FIG. 7 is a perspective view of the holder 11. As illustrated in FIG. 7, the holder 11 has a rectangular tubular shape with open side surfaces on the liquid-phase side and the gas-phase side. The outer shape size of the holder 11 is slightly shorter than the inner size of the housing 7. The height H of the holder 11 (in the direction in which the wick 6 is sandwiched or the direction in which the wick is inserted) is set to such a size that the partition plate 10 can press the wick 6 against the heat receiving plate 8.

Next, the assembly of the evaporator 2 in the present embodiment is described. First, the liquid-side side plate 9 is attached to the liquid-phase-side opening of the housing 7 by welding, bonding, or the like. Next, the holder 11 is inserted from the gas-phase-side opening of the housing 7, and a liquid-phase-side end portion of the holder 11 is brought into contact with the liquid-side side plate 9. Next, the partition plate 10 is inserted from the gas-phase-side opening of the housing 7 and brought into contact with the gas-phase-side end portion of the holder 11 to hold the partition plate 10 at a predetermined position of the housing 7. Next, the outer periphery of the partition plate 10 and the inner periphery of the housing 7 are fixed to each other by welding, adhesion, or the like to close the gap between the outer periphery of the partition plate 10 and the inner periphery of the housing 7. Such a configuration can prevent the gas-phase working fluid in the discharge portion 2b from flowing back to the reservoir portion 2a from between the partition plate 10 and the inner peripheral surface of the housing 7.

Next, the wick 6 having an outer shape size shorter than the inner size of the housing 7 is inserted from the gas-phase-side opening of the housing 7 and is assembled to the housing 7 to close the opening 10c of the partition plate 10. Next, the wick 6 assembled to the housing 7 is pressed toward the partition plate 10, and the heat receiving plate 8 is assembled to the gas-phase-side opening of the housing 7 while the wick 6 is compressively deformed. Then, the heat receiving plate 8 is fixed to the housing 7 by welding, adhesion, or the like. Thus, the evaporator 2 is assembled.

As described above, in the present embodiment, in order to prevent the gas-phase working fluid from flowing back to the reservoir portion, the surface with which the wick is brought into close contact is the gas-phase-side surface 10a of the partition plate 10 perpendicular to the direction in which the wick 6 is inserted into the housing 7. Thus, unlike a configuration in which the surface of the housing parallel to the insertion direction of the wick 6 is brought into close contact with the wick for preventing the gas-phase working fluid from flowing back to the reservoir portion, the wick 6 can be assembled in the housing 7 with a gap between the wick 6 and the inner peripheral surface of the housing 7 parallel to the insertion direction of the wick 6. Thus, the wick 6 can be more easily assembled.

The length of the wick 6 in the insertion direction of the wick 6 when the wick 6 is not assembled is longer than the length from the gas-phase-side surface 10a of the partition plate 10 to the gas-phase-side opening of the housing 7. Accordingly, when the heat receiving plate 8 is attached to the gas-phase-side opening of the housing 7, the wick 6 is pressed toward the partition plate 10 while being compressed and deformed, thus allowing the wick 6 to be brought into close contact with the gas-phase-side surface 10a of the partition plate 10. Such a configuration can prevent the gas-phase working fluid from flowing back to the reservoir portion 2a from between the wick 6 and the gas-phase-side surface 10a of the partition plate 10.

The surface of the wick 6 facing the heat receiving plate 8 is flat, and the inner surface of the heat receiving plate 8 (the surface in close contact with the wick) is also flat. When the heat receiving plate 8 is attached to the gas-phase-side opening of the housing 7, such a configuration allows the wick 6 to be uniformly pressed toward the partition plate 10, thus reducing the occurrence of deviation in the adhesion force between the partition plate 10 and the wick 6. Such a configuration also allows the wick 6 to uniformly adhere to the heat receiving plate 8.

In the present embodiment, the holder 11 is provided to hold the partition plate 10 at a predetermined position in the housing 7. In some embodiments, for example, the holder 11 may be provided on the liquid-side side plate 9, or a stepped holding portion may be provided on the inner peripheral surface of the housing 7 and the partition plate may be held by the stepped holding portion. Alternatively, the holder 11 may be removed from the housing 7 after the outer periphery of the partition plate 10 and the inner periphery of the housing 7 are fixed by welding or adhesion.

Further, for example, after the wick 6 is attached to the heat receiving plate 8 by adhesion or the like, the heat receiving plate 8 may be attached to the gas-phase-side opening of the housing 7 while the wick 6 is inserted into the housing 7 to which the partition plate 10 or the like is attached. Alternatively, after the wick 6 is attached to the gas-phase-side surface 10a of the partition plate 10 by adhesion or the like, an integral unit of the wick 6 and the partition plate 10 may be inserted into the housing.

The insertion of the wick 6 into the housing 7 is not limited to the case of moving the wick 6 into the housing, and the wick may be inserted into the housing in such a manner that the housing is moved to cover the wick. Furthermore, after the heat receiving plate 8 is attached to the gas-phase side of the housing 7, the wick 6, the partition plate 10, and the holder 11 may be inserted into the housing in this order, and then the liquid-side side plate 9 may be assembled to the housing.

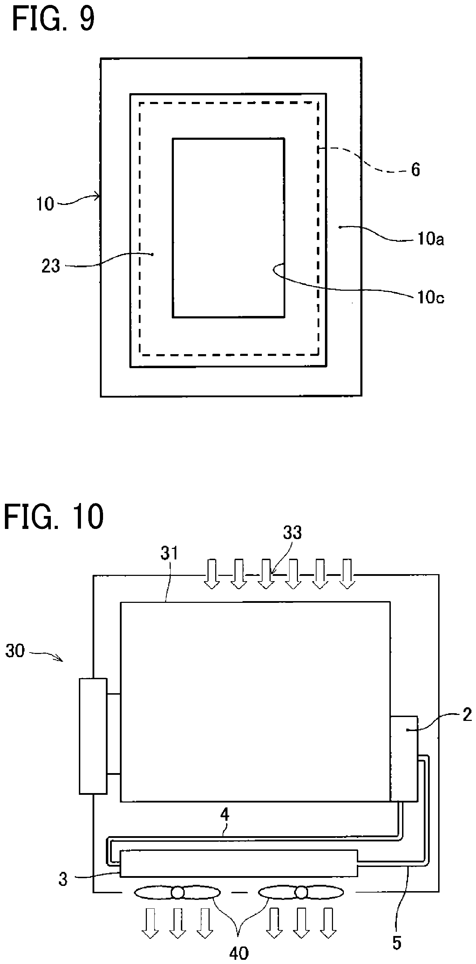

Next, an evaporator 20 according to a variation is described. FIG. 8 is a schematic cross-sectional view of the evaporator 20 according to a variation. FIG. 9 is a plan view of the partition plate 10 and a gasket 23 mounted on the evaporator 20 according to the variation. In the case where the wick 6 of the evaporator 2 of the present variation is made of a hard material such as metal, the wick 6 does not come into close contact with the gas-phase-side surface of the partition plate 10, and the gas-phase working fluid in the discharge portion 2b may flow back to the reservoir portion from between the wick 6 and the partition plate 10. Therefore, in the present variation, the gasket 23 as an elastic member is provided between the wick 6 and the partition plate 10.

The gasket 23 is made of silicone rubber or ethylene propylene diene monomer (EPDM) rubber. As illustrated in FIGS. 8 and 9, the gasket 23 has an opening having a similar shape to the opening 10c of the partition plate 10 and is provided on the gas-phase-side surface 10a of the partition plate 10 to surround the opening 10c. The outer shape of the gasket 23 is larger than the outer shape of the wick 6 indicated by the broken line in FIG. 9.

In the present variation, the wick 6 is made of a hard material and hardly undergoes elastic deformation. Accordingly, when the wick 6 is sandwiched between the heat receiving plate 8 and the partition plate 10 in a state in which the wick 6 is pressed in opposite directions by the heat receiving plate 8 and the partition plate 10, a part of the wick 6 does not enter the opening 10c. Therefore, in the present variation, the mesh member of the partition plate 10 is not obviated.

In the present variation, when the wick 6 is pressed in opposite directions and held by the heat receiving plate 8 and the partition plate 10, the gasket 23 made of an elastic member is compressed and deformed, thus bringing the gasket 23 into close contact with the wick 6. When the gasket 23 is compressed and deformed, the gasket 23 is also brought into close contact with the partition plate 10. Such a configuration can prevent the gas-phase working fluid in the discharge portion 2b from flowing back to the reservoir portion 2a.

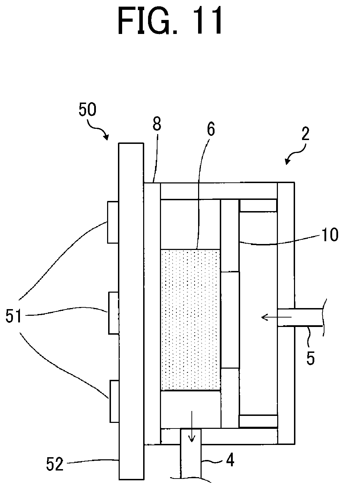

FIG. 10 is a schematic view of an example of an electronic device including the loop heat pipe 1 according to the present embodiment. FIG. 11 is a schematic view of an example of a cooling target of the electronic device in which the heat receiving plate 8 of the evaporator 2 receives heat. The electronic device illustrated in FIG. 10 is an example of a projector 30 including an optical unit 31. The electronic device to which the loop heat pipe 1 according to the present embodiment is applicable is not limited to a projector. The loop heat pipe 1 according to the present embodiment is also applicable to various electronic devices, such as an image forming apparatus such as a printer, a copying machine, a facsimile, or a multifunction peripheral thereof, a personal computer, a server, an electronic blackboard, a television, a Blu-ray recorder, and a game machine.

The heat receiving plate 8 of the evaporator 2 of the loop heat pipe 1 is in contact with a light source unit 50 that is a heat generating portion of the optical unit 31. For example, as illustrated in FIG. 11, the light source unit 50 includes a board 52 and a plurality of surface-emitting light emitting diodes (LEDs) 51 mounted on the board 52. The heat receiving plate 8 of the evaporator 2 is in contact with a surface of the board 52 opposite to a mount surface on which the surface-emitting LEDs 51 are mounted.

The heat receiving plate 8 of the evaporator 2 transfers heat from the board 52 to cool the light source unit 50 being a cooling target. As illustrated in FIG. 10, the condenser 3 is disposed in the vicinity of a cooling fan 40 as an exhaust fan provided on a side surface of a housing of the projector 30. When the cooling fan 40 discharges air to the outside, an air current is generated around the condenser 3. The air current cools the condenser 3, thus enhancing the heat radiation effect in the condenser 3. In addition, an air supply port 33 is provided on a side surface of the housing opposite to the side surface of the housing on which the cooling fan 40 is provided. Air sucked from the air supply port 33 passes through the projector 30 and is discharged from the cooling fan 40.

In this example, the loop heat pipe 1 and the cooling fan 40 to enhance the heat radiation effect of the loop heat pipe 1 are provided as the cooling device to cool the projector. In some embodiments, for example, a blowing fan to blow air to the condenser 3 may be provided instead of the cooling fan 40. Alternatively, the cooling device may include only the loop heat pipe without the fan.

Further, the loop heat pipe according to the present embodiment and the cooling device including the loop heat pipe can be widely applied to devices other than electronic devices. For example, the loop heat pipe or the cooling device according to the present embodiment may be applied to a cooling device to cool, for example, a chemical plant including a reactor.

The embodiments described above are part of examples and, for example, can attain advantages below in the following aspects.
Aspect 1
   In an evaporator such as the evaporator 2 used for a loop heat pipe, a heat receiving portion such as the heat receiving plate 8 to receive heat from the outside is provided on the outer surface of an evaporator body such as the housing 7. A body of the evaporator has an internal space that includes an inflow portion such as the reservoir portion 2a into which a working fluid condensed into a liquid phase by a condenser flows and a discharge portion such as the discharge portion 2b to discharge a gas-phase working fluid evaporated by the heat received by the heat receiving portion. The internal space includes a wick such as the wick 6 to which the working fluid flowing into the inflow portion permeates. The evaporator includes a partition such as the partition plate 10 that partitions the internal space into the inflow portion and the discharge portion with the wick. The wick such as the wick 6 is held between a surface portion (in the above-described embodiment, the gas-phase-side surface 10a) of the partition and the heat receiving portion. For example, in an evaporator used for a certain loop heat pipe, a wick may be brought into close contact with an inner peripheral surface of the evaporator body parallel to an insertion direction of the wick into the evaporator body, to prevent a gas-phase working fluid in a discharge portion from flowing back to an inflow portion. In such a configuration, since the wick is brought into close contact with the inner peripheral surface of the evaporator parallel to the insertion direction of the wick, the wick is press-fitted to the evaporator when the wick is assembled to the evaporator. Such a configuration reduces the easiness of assembling the wick to the evaporator, so that improvement in workability has been desired. On the other hand, in Aspect 1, the wick is sandwiched between the surface portion of the partition and the heat receiving portion. Accordingly, the wick is brought into close contact with the surface portion of the partition, thus preventing the gas-phase working fluid in the discharge portion from flowing back to the inflow portion by the contact surface between the surface portion of the partition and the wick. Such a configuration can obviate the necessity of bringing the wick into close contact with the inner peripheral surface of the evaporator body parallel to the insertion direction of the wick, thus allowing the wick to be inserted into and assembled to the evaporator body with a gap between the wick and the inner peripheral surface of the evaporator parallel to the insertion direction of the wick. Further, since the partition is a separate member from the evaporator body such as the housing 7, the partition can be assembled to the evaporator body after the wick is inserted into the evaporator body. Accordingly, pressing the wick toward the heat receiving portion side by the surface portion of the partition allows the wick to be sandwiched between the surface portion of the partition and the heat receiving portion. Therefore, the wick can be assembled to the evaporator body without press-fitting the wick between the surface portion of the partition and the heat receiving portion. Thus, the wick can be easily assembled. Furthermore, in Aspect 1, the wick is also in close contact with the heat receiving portion, thus allowing the heat received by the heat receiving portion to be favorably transferred to the wick. Accordingly, the liquid-phase working fluid having permeated into the wick can be efficiently evaporated into a gas phase, thus enhancing the cooling effect.
Aspect 2
   In Aspect 1, the surface of the wick such as the wick 6 that contacts the heat receiving portion such as the heat receiving plate 8 is a flat surface. The wick such as the wick 6 has grooves such as the plurality of vapor grooves 6a to evaporate the working fluid from a liquid phase to a gas phase. The grooves are arranged side by side in a direction orthogonal to the direction in which the wick such as the wick 6 is sandwiched between the heat receiving portion and the partition such as the partition plate 10. According to the configuration, as described in the above-described embodiment, the flat surface of the wick such as the wick 6 that contacts the heat receiving portion such as the heat receiving plate 8 allows the wick such as the wick 6 to be uniformly pressed toward the partition by the heat receiving portion such as the heat receiving plate 8. Thus, the occurrence of deviation in the adhesion force between the partition and the wick can be restrained. Further, the wick such as the wick 6 can be uniformly brought into close contact with the heat receiving portion.
Aspect 3
   In Aspect 1 or 2, an opening such as the opening 10c is formed in the partition such as the partition plate 10, and a mesh member such as the mesh member 10b is provided in the opening. According to the configuration, as described in the above-described embodiment, the mesh member can press a portion of the wick facing the opening such as the opening 10c of the partition, thus allowing the wick to be favorably brought into close contact with the heat receiving portion such as the heat receiving plate 8. Further, when the wick such as the wick 6 is sandwiched between the partition and the heat receiving portion, the mesh member can prevent a part of the wick such as the wick 6 from entering the opening, thus preventing deformation of the surface of the wick such as the wick 6 facing the partition. Accordingly, a decrease in the adhesion between the surface portion such as the gas-phase-side surface 10a of the partition and the wick such as the wick 6 can be restrained. The mesh member does not hamper the liquid-phase working fluid in the inflow portion such as the reservoir portion from penetrating into the wick such as the wick 6 through the opening of the partition.
Aspect 4
   In any one of Aspects 1 to 3, the outer shape size of the contact surface of the wick such as the wick 6 that comes into contact with the partition such as the partition plate 10 is larger than the outer shape size of the opening such as the opening 10c of the partition. According to the configuration, as described in the above-described embodiment, the wick can be brought into close contact with the periphery of the opening of the surface portion of the partition, thus preventing the gas-phase working fluid in the discharge portion from flowing back to the inflow portion through the opening.
Aspect 5
   In any one of Aspects 1 to 4, the wick such as the wick 6 is an elastic member. According to the configuration, as described in the above-described embodiment, the wick such as the wick 6 can be sandwiched between the heat receiving portion such as the heat receiving plate 8 and the partition such as the partition plate 10 with the wick being compressed and deformed by the heat receiving portion and the partition. Accordingly, a restoring force acts on the wick such as the wick 6 in a direction to increase the adhesion between the wick and the surface portion of the partition, thus allowing the surface portion of the partition and the wick such as the wick 6 to preferably prevent the reverse flow of the gas-phase working fluid in the discharge portion to the inflow portion. Further, the adhesion between the heat receiving portion and the wick such as the wick 6 is increased, thus allowing the heat received by the heat receiving portion to be favorably transferred to the wick.
Aspect 6
   In Aspect 5, the wick is a porous silicone rubber. According to the configuration, compared with the case where the wick is made of a porous metal, the cost of the wick can be reduced, and the cost of the apparatus can be reduced.
Aspect 7
   A loop heat pipe, such as the loop heat pipe 1, includes the evaporator, such as the evaporator 2, according to any one of Aspects 1 to 6 to receive heat from the outside to evaporate a working fluid from a liquid phase to a gas phase and a condenser, such as the condenser 3, to condense the gas-phase working fluid discharged from the evaporator to the liquid phase. As described in the above-described embodiment, such a configuration can easily assemble the wick, prevent the gas-phase working fluid from flowing back to the inflow portion, and favorably circulate the working fluid.
Aspect 8
   An electronic device such as the projector 30 includes the loop heat pipe according to Aspect 7. Such a configuration can achieve high cooling performance and stable operation.

## Claims

1. An evaporator (2) for use in a loop heat pipe (1), the evaporator (2) comprising:
an evaporator body (7) including an internal space;
a heat receiving portion (8) forming an outer surface of the evaporator body (7) to receive heat from an outside of the evaporator body (7);
an inflow portion (2a) in the internal space, into which a working fluid condensed into a liquid phase by a condenser (3) flows;
a discharge portion (2b) in the internal space, to discharge a gas-phase working fluid evaporated by the heat received by the heat receiving portion (8);
a wick (6) in the internal space, into which the working fluid flowing into the inflow portion (2a) permeates; and
a partition (10) partitioning the internal space into the inflow portion (2a) and the discharge portion with the wick,
the wick (6) being sandwiched between a surface (10a) of the partition (10) and the heat receiving portion (8).

2. The evaporator (2) according to claim 1,
wherein the wick (6) has a flat surface contacting the heat receiving portion (8),
wherein the wick (6) has a plurality of grooves (6a) to evaporate the working fluid from the liquid phase to a gas phase, and
wherein the plurality of grooves is arranged side by side in a direction orthogonal to a direction in which the heat receiving portion (8) sandwiches the wick (6) with the partition (10).

3. The evaporator (2) according to claim 1 or 2, further comprising a mesh member (10b) covering an opening (10c) of the partition (10).

4. The evaporator (2) according to any one of claims 1 to 3,
wherein the wick (6) has a contact surface contacting the partition (10), and
wherein an outer shape size of the contact surface is larger than an opening of the partition (10).

5. The evaporator (2) according to any one of claims 1 to 4,
wherein the wick (6) is an elastic member.

6. The evaporator (2) according to claim 5,
wherein the wick (6) is a porous silicone rubber.

7. A loop heat pipe (1) comprising:
the evaporator (2) according to any one of claims 1 to 6 to receive the heat from the outside of the evaporator body to evaporate the working fluid from the liquid phase to a gas phase; and
the condenser (3) connected to the evaporator (2) to condense the gas-phase working fluid discharged from the evaporator (2) into the liquid phase.

8. An electronic device (30) comprising the loop heat pipe (1) according to claim 7.
